(19) Europäisches Patentamt
European Patent Office
Office européen des brevets

(11) **EP 2 021 812 B1**

(12) **EUROPÄISCHE PATENTSCHRIFT**

(45) Veröffentlichungstag und Bekanntmachung des Hinweises auf die Patenterteilung:
**28.12.2016   Patentblatt 2016/52**

(21) Anmeldenummer: **07724635.3**

(22) Anmeldetag: **26.04.2007**

(51) Int Cl.:
***G01R 21/14*** *(2006.01)*

(86) Internationale Anmeldenummer:
**PCT/EP2007/003705**

(87) Internationale Veröffentlichungsnummer:
**WO 2007/137660 (06.12.2007 Gazette 2007/49)**

(54) **MESSVORRICHTUNG MIT GEGENGEKOPPELTEM GLEICHSPANNUNGSVERSTÄRKER**

MEASURING DEVICE COMPRISING A DC AMPLIFIER WITH NEGATIV FEEDBACK

DISPOSITIF DE MESURE COMPRENANT UN AMPLIFICATEUR DE TENSION CONTINUE À CONTRE-RÉACTION

(84) Benannte Vertragsstaaten:
**DE FR GB**

(30) Priorität: **26.05.2006   DE 102006024699**

(43) Veröffentlichungstag der Anmeldung:
**11.02.2009   Patentblatt 2009/07**

(73) Patentinhaber: **Rohde & Schwarz GmbH & Co. KG**
**81671 München (DE)**

(72) Erfinder:
• **REICHEL, Thomas**
**85598 Baldham (DE)**
• **BRATFISCH, Toralf**
**85640 Putzbrunn (DE)**
• **KATZER, Michael**
**80337 München (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
**EP-A2- 0 405 593      WO-A-01/36988**
**DE-A1- 2 422 030      DE-A1- 19 710 474**
**DE-A1- 19 913 338      US-A- 4 970 456**
**US-A- 5 373 237**

**Beschreibung**

Die Erfindung betrifft eine Messvorrichtung mit einem Gleichspannungsverstärker insbesondere zum Messen der Hüllkurvenleistung und/oder des Leistungsmittelwerts eines Hochfrequenzsignals.

Eine solche Messvorrichtung ist aus der DE 199 55 342 A1 bekannt. Mit der aus dieser Druckschrift hervorgehenden Messvorrichtung kann sowohl die Hüllkurvenleistung als auch der Leistungsmittelwert bzw. Effektivwert gemessen werden. Um einen möglichst großen Dynamikbereich abzudecken, ist der Messbereich in mehrere Teilbereiche aufgeteilt, die jeweils mehreren parallel angeordneten Messzweigen zugeordnet sind. In jedem Messzweig ist jeweils ein Zerhacker (Chopper) angeordnet, die beide synchron angesteuert werden. Außerdem ist in jedem Messzweig ein Analog/Digital-Wandler angeordnet, der mit einer synchronen Taktrate versorgt wird. Nach gewichteter Addition der digitalisierten Messsignale der einzelnen Messzweige erfolgt eine synchrone Demodulation, bevor das Signal ausgewertet wird.

Nachteilig bei der aus der DE 199 55 342 A1 bekannten Messvorrichtung ist die Verwendung paralleler Messzweige, wodurch die Messvorrichtung sehr aufwendig gestaltet ist. Neben der Synchronisierung der Chopper und der Analog/Digital-Wandler ist dafür Sorge zu tragen, dass die Gruppenlaufzeit des Messsignals in allen Messzweigen exakt gleich groß ist. Dies bereitet in der Praxis insbesondere bei zu realisierenden Video-Bandbreiten in der Größenordnung von 30 MHz Schwierigkeiten. Bei einer nur einpfadigen Realisierung der Messvorrichtung muss für eine ausreichende Kompression des Dynamikbereichs Sorge getragen werden. Außerdem wird ein Verstärker mit geringem Rauscheinfluss und einer nur geringen Temperaturabhängigkeit der Übertragungskennlinie benötigt.

Aus der US Patentschrift 4,970,456 ist ein temperaturkompensierter Leistungsdetektor bekannt. Um ungewollte Temperatureffekte einer Detektordiode am Eingang eines Verstärkers des Leistungsdetektors zu kompensieren, weist der Verstärker im Gegenkopplungspfad eine temperatureffektkompensierende Diode auf.

Aus der Offenlegungsschrift DE 24 22 030 A1 ist ein temperaturkompensierter Hochfrequenzsignalgleichrichter bekannt. Um ungewollte Temperatureffekte einer Gleichrichterdiode am Eingang eines Verstärkers des HF-Signalgleichrichters zu kompensieren, weist der Verstärker im Gegenkopplungspfad eine temperatureffektkompensierende Diode auf.

Der Erfindung liegt die Aufgabe zugrunde, eine Messvorrichtung insbesondere zum Messen der Hüllkurvenleistung und/oder des Leistungsmittelwerts eines Hochfrequenzsignals zu schaffen, welche einen Verstärker mit geringem Rauscheinfluss und welche eine sehr geringe Temperaturabhängigkeit der Übertragungskennlinie hat.

Die Aufgabe wird durch eine Messvorrichtung mit den Merkmalen des Anspruchs 1 gelöst. Die abhängigen Ansprüche enthalten vorteilhafte Weiterbildungen der Erfindung.

Erfindungsgemäß wird vorgeschlagen, den Gleichspannungsverstärker mit Gegenkopplungspfaden zu versehen, die jeweils einen Ausgang mit einem Eingang verbinden und in welchen sich jeweils ein weiteres Detektorelement befindet. Auf diese Weise wird eine Gegenkopplung geschaffen, die eine ähnliche Charakteristik hat, wie der Detektor, weil im Detektor und in den Gegenkopplungspfaden im wesentliche gleiche Detektorelemente verwendet werden.

Der Gleichspannungsverstärker ist vorzugsweise als Differenzverstärker ausgebildet und verstärkt eine Differenz-Eingangsspannung zwischen seinen beiden Eingängen zu einer Differenz-Ausgangsspannung zwischen seinen beiden Ausgängen. In diesem Fall sind zwei Rückkopplungspfade vorhanden: Ein erster Rückkopplungspfad vom ersten Ausgang zum ersten Eingang und ein zweiter Rückkopplungspfad vom zweiten Ausgang zum zweiten Eingang. In jedem dieser beiden Rückkopplungspfade ist dann jeweils ein Detektorelement angeordnet, das die Rückkopplung bestimmt. Anstatt eines Differenzverstärkers kann zwischen dem ersten Eingang und dem ersten Ausgang und dem zweiten Eingang und dem zweiten Ausgang aber auch jeweils ein separater Verstärker, beispielsweise jeweils ein Operationsverstärker, verwendet werden.

Der Detektor hat zwei Detektorelemente. Dies ist insbesondere bei Verwendung von Detektordioden vorteilhaft, die in dem Detektor in umgekehrter Polung angeordnet sind und dann im Sinne einer Zweiweg-Gleichrichtung jeweils eine Halbwelle des Hochfrequenz-Eingangssignals detektieren. In diesem Fall ist der Chopper (Zerhacker) als Umschalter ausgebildet, der während einer ersten Chop-Phase das erste Detektorelement bzw. die erste Detektordiode mit dem ersten Eingang des Gleichspannungsverstärkers und während der gleichen Chop-Periode das zweite Detektorelement bzw. die zweite Detektordiode mit dem zweiten Eingang des Gleichspannungsverstärkers verbindet. In der zweiten Chop-Periode ist die Belegung der Eingänge dann umgekehrt. Während der ersten Chop-Phase empfängt somit der erste Eingang des Gleichspannungsverstärkers ein Signal, das im wesentlichen aus der detektierten positiven Halbwelle erzeugt wird, während der zweite Eingang des Gleichspannungsverstärkers ein Signal empfängt, das im wesentlichen aus der detektierten negativen Halbwelle erzeugt wird. Während der zweiten Chop-Phase ist dies dann umgekehrt.

In diesem Fall ist es vorteilhaft, wenn in beiden Rückkopplungspfäden jeweils zwei Detektorelemente angeordnet sind. Wenn die Detektorelemente Detektordioden sind, so sind diese Detektordioden antiparallel anzuordnen, so dass bei einer ersten Chop-Phase in dem jeweiligen Rückkopplungspfad jeweils im wesentlichen eine erste Detektordiode die Größe der Rückkopplung bestimmt und bei der anderen Chop-Phase die jeweils andere Detektordiode im wesentlichen die Größe der Rückkopplung bestimmt. Dies ist dann jeweils immer die Diode, welche in Flussrichtung gepolt ist, während die antiparallel angeordnete andere Diode dann jeweils sperrt und somit das Rückkopplungssignal so gut wie nicht beeinflusst.

Es ist vorteilhaft, wenn der Differenz-Verstärker einen Regeleingang zum Regeln der Symmetrie des Ausgangssignals hat. In diesem Fall ist es vorteilhaft, die beiden Eingänge des Differenz-Verstärkers über ein symmetrisches Netzwerk, beispielsweise zwei Widerstände, und über einen Integrator mit dem Regeleingang zu verbinden. Der Integrator kann in einfacher Weise als Operationsverstärker mit einem Kondensator zwischen dem Ausgang und dem invertierenden Eingang ausgebildet sein.

Ein Ausführungsbeispiel der Erfindung wird nachfolgend unter Bezugnahme auf die Zeichnung beispielhaft näher beschrieben. In der Zeichnung zeigen:

Fig. 1    eine Messvorrichtung nach dem Stand der Technik;

Fig. 2    eine Gesamtdarstellung einer Messvorrichtung;

Fig. 3    ein Schaltungs-Beispiel des Detektors und des Verstärkers einer Messvorrichtung des Standes der Technik nach Fig. 1;

Fig. 4    das Ersatzschaltbild für kleine Leistungen mit Spannungsrauschen des Verstärkers bei der Messvorrichtung nach dem Stand der Technik gemäß Fig. 3;

Fig. 5    ein Ausführungsbeispiel des Detektors, Choppers und Verstärkers einer Messvorrichtung nach Fig. 2 und

Fig. 6    das Ersatzschaltbild für kleine Leistungen mit Spannungsrauschen des Verstärkers bei der erfindungsgemäßen Messvorrichtung gemäß Fig. 5.

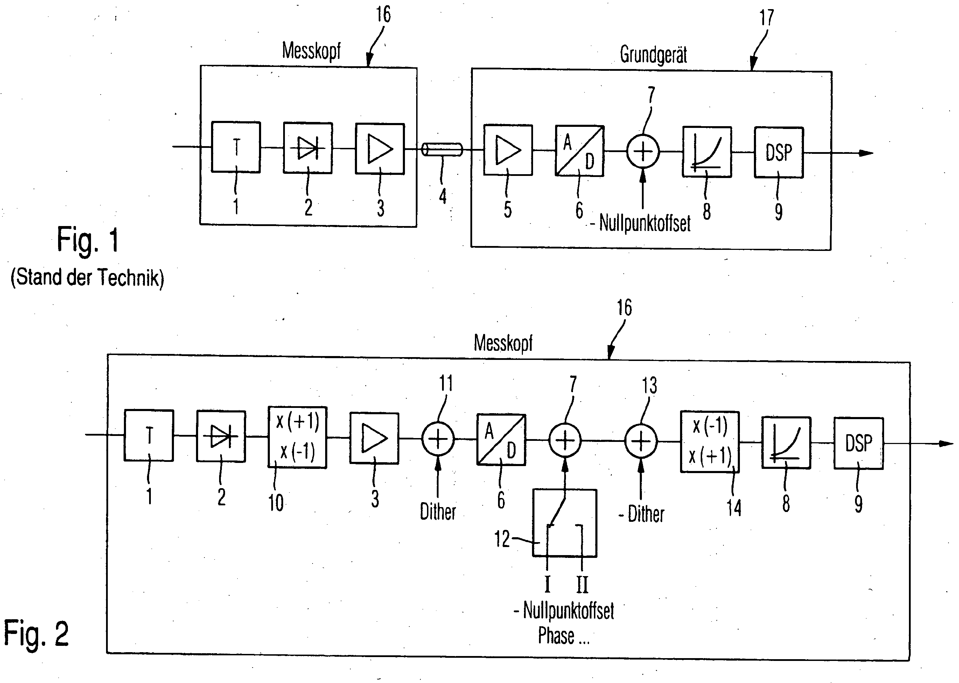

Fig. 1 zeigt eine bislang übliche Konfiguration einer Messvorrichtung zum Messen der Hüllkurvenleistung und des Leistungsmittelwerts. In einem Messkopf 16 sind ein Dämpfungsglied 1, ein Hüllkurven-Detektor 2, der als Dioden-Detektor ausgebildet ist, und ein Vorverstärker bzw. Leitungstreiber 3 angeordnet. Der Messkopf 16 ist über ein Verbindungskabel 4 mit dem Grundgerät 17 verbunden. In dem Grundgerät 17 befindet sich der Hauptverstärker 5, ein Analog/Digital-Wändler 6, eine Summierstufe 7 zur Subtraktion des Nullpunkt-Offsets, eine Einrichtung 8 zur Kennlinienkorrektur und ein digitaler Signalprozessor mit weiteren Auswertefunktionen, beispielsweise zur Hüllkurvenanzeige, zur Berechnung des Leistungsmittelwerts usw.. Die Einrichtung zur Kennlinienkorrektur 8 und der digitale Signalprozessor 9 bilden zusammen eine Auswerteeinrichtung 8, 9.

Fig. 2 zeigt eine Messvorrichtung in einem Modus, der zur Messung der Hüllkurvenleistung dient. Ein Unterschied zu der Konfiguration nach Fig. 1 besteht darin, dass sämtliche Komponenten der Messvorrichtung bevorzugt im Messkopf 16 angeordnet sein können. Ein spezielles Grundgerät nur für die Leistungsmessung ist dann unter Umständen nicht mehr notwendig. Der Messkopf 17 kann beispielsweise über einen USB-Bus unmittelbar an einen PC angeschlossen werden.

Der weitere Unterschied besteht darin, dass zwischen dem Detektor 2 und dem Analog/Digital-Wandler 6 bevorzugt nach dem Verstärker 3, eine Einspeiseeinrichtung 11 zum Einspeisen eines Dithersignals angeordnet ist. Dabei speist die Einspeiseeinrichtung 11 bevorzugt für die Messung der Hüllkurvenleistung ein erstes Dithersignal "Dither" ein und für die Messung des Leistungsmittelwerts ein anderes, in Fig. 2 nicht veranschaulichtes zweites Dithersignal ein.

Das erste Dithersignal kann an einer Dither-Eliminierungseinrichtung 13 aus dem durch den Analog/Digital-Wandler 6 digitalisierten Messsignal wieder eliminiert werden. In Fig. 2 besteht die Dither-Eliminierungseinrichtung 11 für das Dithersignal ("Dither") aus einem Addierer, welchem das digitale Äquivalent des ersten Dithersignals mit invertiertem Vorzeichen ("-Dither ") zugeführt wird, so dass das digitale Äquivalent des Dithersignals von dem digitalisierten Messsignal subtrahiert wird.

Außerdem ist zwischen dem Detektor 2 und dem Gleichspannungsverstärker 3 ein Zerhacker (Chopper) 10 angeordnet. Der Chopper 10 zerhackt das Messsignal, indem zyklisch das Vorzeichen des analogen Signals invertiert wird. Das Zerhacken hat den Vorteil, das der Einfluss der thermischen Drift des Gleichspannungsverstärkers 3 erheblich reduziert wird. Des weiteren wird der Einfluss des 1/f-Rauschens reduziert. Hinter dem Analog/DigitalWandler 6 befindet sich ein Synchrondemodulator 14, der das digitalisierte Messsignal synchron zu dem Chopper 10 mit -1 bzw. +1 multipliziert und somit den Einfluss des Choppers 10 eliminiert. Dieser Vorzeichenwechsel kann ohne echte Multiplikation nummerisch sehr einfach vollzogen werden.

Eine weitere Besonderheit bei der in Fig. 2 dargestellten Messvorrichtung besteht noch darin, dass die Einrichtung 7, 12 zur Korrektur des Nullpunktversatzes eine Umschalteinrichtung 12 aufweist, welche eine unterschiedliche Nullpunkt-Korrektur für die beiden Chop-Phasen +1 und -1 des Choppers 10 ermöglicht. Die Nullpunkt-Offsets können für die beiden Chop-Phasen in einer nicht dargestellten Speichereinrichtung unabhängig voneinander gespeichert werden. Die Umschalteinrichtung 12 wird synchron zu dem Chopper 10 betrieben.

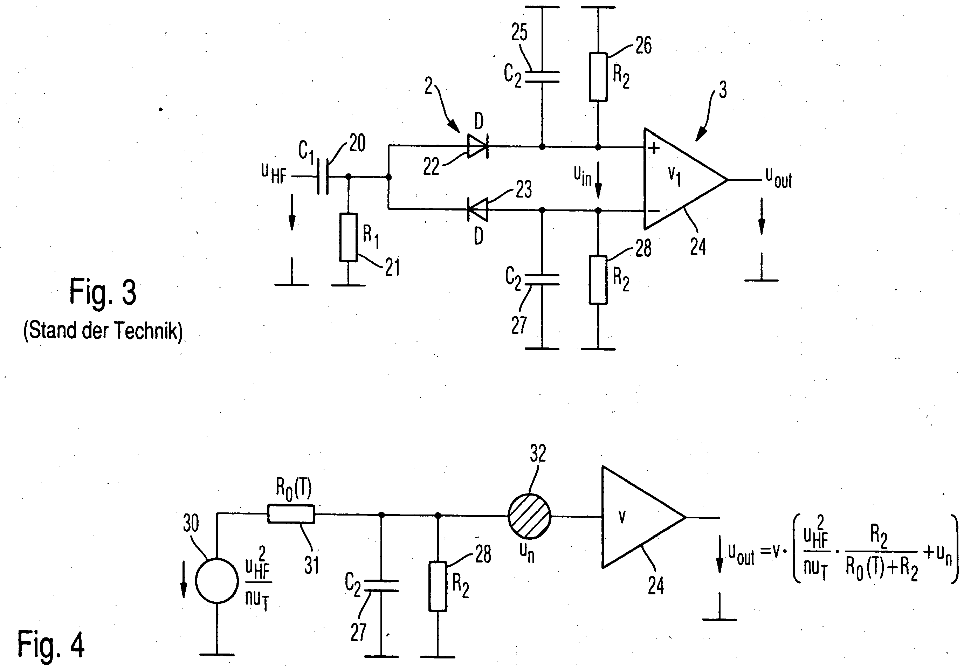

Fig. 3 zeigt einen typischen Aufbau des Messkopfes 16 im Bereich des Detektors 2 und des Gleichspannungsverstärkers 3. Der Detektor 2 besteht aus zwei Detektor-Dioden 22 und 23, die in jeweils unterschiedlicher Polung einerseits mit einem Hochpass bestehend aus dem Serienkondensator 20 und dem Widerstand 21, und andererseits mit jeweils einem der beiden Eingänge des Gleichspannungsverstärkers 24 verbunden sind. An den Ausgängen der Detektordioden 22 und 23 bzw. den Eingängen des Gleichspannungsverstärkers 24 ist jeweils ein Ladekondensator 25 bzw. 27, der von den Detektordioden 22 bzw. 23 geladen wird, und ein Entladewiderstand 26 bzw. 28 zum Entladen der Ladekondensatoren 25 und 27 jeweils gegen Masse geschaltet.

Fig. 4 zeigt das Ersatzschaltbild für kleine Leistungen mit Spannungsrauschen des Verstärkers 3 nach dem Stand der Technik gemäß Fig. 3. Das Ersatzschaltbild beschreibt das temperaturabhängige Rauschverhalten der Verstärkerschaltung. Eine Ersatzspannungsquelle 30 erzeugt eine Spannung $u^2_{HF}/nu_T$, wobei $u_{HF}$ die Eingangsspannung des zu detektierenden Hochfrequenzsignals und $u_T$ die Temperatur-Spannung $u_T=k\cdot T/e$ darstellt. n ist ein technologieabhängiger Idealitätsfaktor, k ist die Boltzmannkonstante, T ist die absolute Temperatur und e ist die Elementarladung. Die Spannungsquelle 30 ist über den Widerstand 31 mit dem Widerstandswert $R_0(T)$, welcher den Nullpunktwiderstand (Video Resistance) der Gleichrichterdiode 22 beschreibt, mit dem Ladekondensator 27 und dem Entladewiderstand 28 verbunden. Am Eingang des Verstärkers 24 befindet sich im Ersatzschaltbild noch die Rauschspannungsquelle 32, die das Eigenrauschen $u_n$ des Verstärkers 24 modelliert. Der Verstärker 24 hat einen Verstärkungsfaktor von v.

Die Spannungsquelle 30 wirkt über den Spannungsteiler bestehend aus den Widerständen 31 und 28 auf den Eingang des Verstärkers 24. Somit ergibt sich die Ausgangsspannung $u_{out}$ des Verstärkers 24 zu

$$u_{out} = v \cdot \left( \frac{u_{HF}^2}{nu_T} \cdot \frac{R_2}{R_0(T) + R_2} + u_n \right) \qquad (1)$$

Wie aus der Gleichung (1) ersichtlich ist, leidet die in Fig. 3 dargestellte klassische Verstärkungsschaltung an einer erheblichen Temperaturabhängigkeit bei kleinen Signalen. Die Ursache hierfür ist die exponentielle Temperaturabhängigkeit des Nullpunktwiderstandes $R_0(T)$ der Gleichrichterdioden 22 und 23.

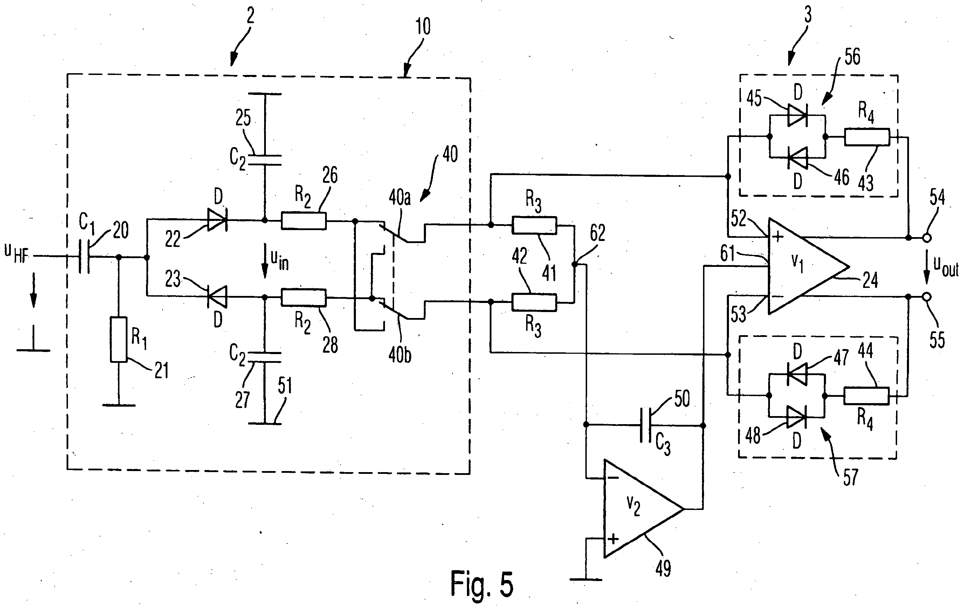

Abhilfe schafft die erfindungsgemäße Schaltung, von welcher ein Ausführungsbeispiel in Fig. 5 dargestellt ist. Bereits anhand von Fig. 3 beschriebene Elemente sind mit übereinstimmenden Bezugszeichen versehen, so dass sich insoweit eine wiederholende Beschreibung erübrigt. Auch bei der in Fig. 5 dargestellten erfindungsgemäßen Ausgestaltung sind zwei Detektordioden 22 und 23 vorhanden, die über einen Hochpass bestehend aus dem Kondensator 20 und dem Widerstand 21 die zu detektierende Hochfrequenzspannung $u_{HF}$ empfängt. Der Kondensator 20 dient gleichzeitig als Trenn-Kondensator für eventuelle Gleichspannungsanteile des zu detektierenden Signals.

Die mit ihrer Anode dem Eingang zugewandte erste Detektordiode 22 dient im wesentlichen zur Detektion der positiven Halbwelle, während die mit ihrer Kathode dem Eingang zugewandte zweite Detektordiode 23 im wesentlichen zur Detektion der negativen Halbwelle dient. Am Ausgang der Detektordiode 22 bzw. 23 ist jeweils ein Ladekondensator 25 bzw. 27 vorgesehen, dessen anderer Pol mit der Schaltungsmasse 51 verbunden ist. Die Ausgänge der Detektordioden 22 und 23 sind über jeweils einen Widerstand 26 bzw. 28 und eine Umschalteinrichtung 40 mit einem der beiden Eingänge 52 bzw. 53 des Gleichspannungsverstärkers 24 verbunden, der im dargestellten Ausführungsbeispiel als Differenz-Verstärker ausgebildet ist. Der Differenzverstärker verstärkt eine zwischen den beiden Eingängen 52 anliegende Differenzspannung in eine Differenzspannung $u_{out}$ zwischen seinen beiden Ausgängen 54 und 55.

Zwischen dem Detektor 2 und dem Verstärker 3 ist der in Fig. 2 gezeigte Chopper (Zerhacker) 10 geschaltet, der im in Fig. 5 dargestellten Ausführungsbeispiel als zweipolige Umschalteinrichtung 40 mit den beiden Umschaltern 40a und 40b ausgebildet ist. Jeweils einer der beiden Eingangspole der Umschalter 40a und 40b ist über jeweils einen der beiden Widerstände 26 bzw. 28 mit einem der beiden Ausgänge der Detektordioden 22 bzw. 23 verbunden. Der Ausgang des ersten Umschalters 40a steht mit dem ersten Eingang 52 des Gleichspannungsverstärkers 24 in Verbindung, während der Ausgang des zweiten Umschalters 40b mit dem zweiten Eingang 53 des Gleichspannungsverstärkers 24 verbunden ist.

In der in Fig. 5 dargestellten ersten Schaltstellung der Umschalteinrichtung 40 steht somit die erste Detektordiode 22 über den Widerstand 26 und den ersten Umschalter 40a mit dem ersten Eingang 52 und die zweite Detektordiode 23 über den Widerstand 28 und den zweiten Umschalter 40b mit dem zweiten Eingang 53 des Gleichspannungsverstärkers 24 in Verbindung. In der anderen Schaltstellung hingegen steht die zweite Detektordiode 23 über den Widerstand 28 und den ersten Umschalter 40a mit dem ersten Eingang des Gleichspannungsverstärkers 24 in Verbindung, während die erste Detektordiode 22 über den Widerstand 26 und den zweiten Umschalter 40b mit dem zweiten Eingang 53 des Gleichspannungsverstärkers 24 verbunden ist. Folglich wechselt in jeder Chop-Phase die Belegung der beiden Eingänge 52 und 53 des Verstärkers 24 mit den beiden Dioden 22 und 23. Die Invertierung des Eingangssignals im Takt der Chopper-Steuerung hat den Vorteil, dass der Einfluss einer thermischen Drift des Gleichspannungsverstärkers 24 deutlich verringert wird, da sich eine solche Drift auf die beiden Chop-Phasen gegenläufig auswirkt und dadurch eliminiert wird. Gleichzeitig sinkt der Einfluss des 1/f-Rauschens.

Erfindungsgemäß ist eine Gegenkopplung vorhanden, wobei sich in jedem Gegenkopplungspfad zumindest ein weiteres Detektorelement bzw. im Ausführungsbeispiel zumindest eine weitere Detektordiode befindet. Bei dem in Fig. 5 dargestellten Ausführungsbeispiel ist zwischen dem ersten Ausgang 52 des als Differenzverstärker ausgebildeten Gleichspannungsverstärkers 24 ein erster Gegenkopplungspfad 56 gebildet, während zwischen dem zweiten Ausgang 55 und dem zweiten Eingang 53 des Differenzverstärkers 24 ein zweiter Gegenkopplungspfad 57 vorgesehen ist. Im in Fig. 5 dargestellten Ausführungsbeispiel umfasst der erste Gegenkopplungspfad 56 eine dritte Detektordiode 45 und eine vierte Detektordiode 46, die zueinander antiparallel angeordnet sind. Ein Widerstand 43, der seriell zu der antiparallelen Anordnung der Detektordioden 45 und 46 geschaltet ist, stellt die Größe der Gegenkopplung so ein, dass der Einfluss von $R_0(T)$ gerade kompensiert wird.

Bei dem zweiten Rückkopplungspfad 57 ist eine fünfte Detektordiode 47 und eine sechste Detektordiode 48 vorgesehen, die ebenfalls antiparallel geschaltet sind, wobei seriell zu der antiparallelen Konfiguration der Detektordioden 47 und 48 wiederum ein die Gegenkopplung bestimmender Widerstand 44 geschaltet ist.

Die dritte bis sechste Detektordiode 45 bis 48 dienen nicht der Detektion des Signals, sondern lediglich der Nachbildung der Charakteristik der ersten und zweiten Detektordiode 22 und 23, so dass die Gegenkopplungspfade 56 und 57 eine Gegenkopplung mit einer Charakteristik bilden, die der Charakteristik der Detektordioden 22 und 23 und der Widerstände $R_2$ nachgebildet ist. Die antiparallele Anordnung der dritten und vierten Detektordiode 45 und 46 einerseits und der fünften und sechsten Detektordiode 47 und 48 andersseitig ist aufgrund des Polaritätswechsels beim Umschalten zwischen den beiden Chop-Phasen vorteilhaft. Während einer ersten Chop-Phase befindet sich die dritte Diode 45 und die fünfte Diode 47 in Durchlassrichtung, während bei der anderen Chop-Phase sich die sechste Diode 48 und die vierte Diode 46 in Durchlassrichtung befindet. Bei kleinen Ausgangsspannungen des Verstärkers sind die Ströme der Dioden in den Gegenkopplungszweigen so klein, dass sie sich auf beide Dioden aufteilen.

Die Größe der Gegenkopplung ist somit aussteuerungsabhängig. Fließt bei einer großen Aussteuerung der Detektordioden 22 und 23 ein großer Strom durch die Detektordioden 22 und 23 und liegt somit eine relativ hohe Differenzspannung $u_{in}$ zwischen den Ladekondensatoren 25 und 27 an, so erzeugt die dadurch verursachte hohe Ausgangsspannung einen relativ hohen Strom durch die gegenkoppelnden Dioden 45 bis 48, was zu einer stärkeren Gegenkopplung als bei einer schwächeren Aussteuerung der Detektordioden 22 und 23 führt.

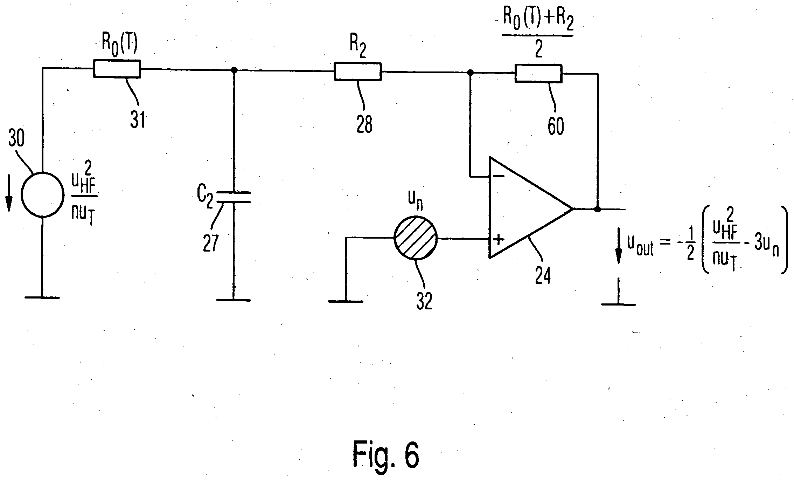

Die Einbeziehung der Charakteristik der Detektordioden in die Gegenkopplung kompensiert den Einfluss der Temperaturabhängigkeit des Nullpunktwiderstands (Video Resistance) der Detektordioden 22 und 23. Dies wird bei Betrachtung des in Fig. 6 dargestellten Ersatzschaltbilds des in Fig. 5 dargestellten Ausführungsbeispiels der erfindungsgemäßen Schaltung für kleine Leistungen mit Berücksichtigung des Spannungsrauschens des Verstärkers 24 deutlich. Mit Fig. 4 übereinstimmende Elemente sind auch hier mit den gleichen Bezugszeichen bezeichnet.

Der Widerstand 28 ist nun als Serienwiderstand zwischen dem ersten Eingang (-) des Verstärkers 24 und dem Nullpunktwiderstand 31 der Detektordioden 22 und 23 geschaltet. Die Spannungsquelle 32 für das Eigenrauschen des Verstärkers befindet sich am anderen Eingang (+) des Verstärkers 24. Neu hinzugekommen ist der Widerstand 60 des Rückkopplungspfads, dessen Widerstandswert ebenfalls von dem Nullpunktwiderstand $R_0(T)$ der Detektordioden bestimmt wird. Die Ausgangsspannung $u_{out}$ ergibt sich somit zu

$$u_{out} = -\frac{1}{2}\left(\frac{u_{HF}^2}{n u_T} - 3u_n\right) \qquad\qquad (2)$$

Die Ausgangsspannung $u_{out}$ ist somit bei der erfindungsgemäßen Schaltung unabhängig von dem Nullpunktwiderstand $R_0(T)$ der Detektordioden, der aufgrund der thermischen Ladungsträgergenerierung in den Dioden über die Boltzmanngleichung exponentiell temperaturabhängig ist. Außerdem wird erreicht, dass der Signal/Rausch-Abstand kaum noch temperaturabhängig und größer als bei der klassischen Schaltung nach Fig. 3 ist, da bei Gleichung (2) $R_0(T)$ eliminiert ist. Aus Gründen, die durch das dynamische Verhalten der Schaltung bedingt sind, ist der Lastwiderstand 26 bzw. 28 möglichst klein zu wählen, bei Raumtemperatur etwa 1/3 bis 1/5 des Nullpunktwiderstands $R_0(T)$.

Der in Fig. 5 dargestellte Differenzverstärker 24 hat vorzugsweise einen Regeleingang 61 zur Gleichtaktregelung, also zur Regelung der Symmetrie der Ausgangsspannung. Aufgrund unterschiedlicher Offsetspannungen kommt es auch bei exakt gleicher Ansteuerung der beiden Eingänge zu unterschiedlichen Spannungen an den beiden Ausgängen. Dies muss durch die Gleichtaktregelung eliminiert werden. Beim in Fig. 5 dargestellten Ausführungsbeispiel sind die beiden Eingänge 52 und 53 des Verstärkers 24 deshalb über ein symmetrisches Netzwerk aus den beiden Widerständen 41 und 42 und einem aus dem Operationsverstärker 49 und dem Kondensator 50 gebildeten Integrator mit dem Gleichtakt-Eingang 61 verbunden. Die Spannung am Schaltungsknoten 62 muss im zeitlichen Mittel gleich Null sein. Ist sie dies nicht, führt dies zu einer Regelspannung am Regeleingang 61, bis die Symmetrie wieder hergestellt ist.

Anstelle des in Fig. 5 dargestellten Differenzverstärkers 24 können auch die beiden Ausgänge des Detektors 2 mit separaten invertierenden Verstärkern, beispielsweise gebildet durch Operationsverstärker, beschaltet werden. Die Differenzbildung findet dann später beispielsweise in einem dritten Operationsverstärker statt. Die in Fig. 5 dargestellte Schaltung mit dem Differenzverstärker hat jedoch den Vorteil, dass die durch die Offset-Spannungsdrift des Verstärkers hervorgerufene Nullpunktdrift deutlich reduziert ist. Die Gleichtaktregelung unterdrückt zusätzlich den Einfluss der Eingangs(Bias)-Ströme des Verstärkers 24 auf die Nullpunktdrift.

Anstatt einer Detektordiode können auch andere Detektorelemente beispielsweise thermische Detektorelemente verwendet werden, wobei es dann sinnvoll ist, auch diese Detektorelemente in den Rückkopplungspfaden vorzusehen, so dass auch hier die Rückkopplungspfade die gleiche Charakteristik haben, wie die Detektorelemente.

**Patentansprüche**

1. Messvorrichtung für ein Hochfrequenzsignal mit einem Detektor (2) mit zumindest einem Detektorelement (22; 23) und einem dem Detektor(2) nachgeschalteten Gleichspannungsverstärker (24) mit zumindest einem Eingang (52; 53) und zumindest einem Ausgang (54; 55),
wobei der Gleichspannungsverstärker (24) zumindest einen Gegenkopplungspfad (56; 57) aufweist, der sich von seinem zumindest einen Ausgang (54; 55) zu seinem zumindest einen Eingang (52; 53) erstreckt,
wobei sich in dem Gegenkopplungspfad (56; 57) zumindest ein weiteres Detektorelement (45-48) befindet,
wobei das weitere Detektorelement (45-48) im Wesentlichen gleich dem Detektorelement (22; 23) ist und die gleiche Charakteristik des Detektorelements (22; 23) aufweist, wobei der Gleichspannungsverstärker (24) einen ersten Eingang (52) und einen zweiten Eingang (53) sowie einen ersten Ausgang (54) und einen zweiten Ausgang (55) aufweist,
wobei der erste Ausgang (54) mit dem ersten Eingang (52) über einen ersten Gegenkopplungspfad (56) und der zweite Ausgang (55) mit dem zweiten Eingang (53) über einen zweiten Gegenkopplungspfad (57) verbunden ist und wobei jeder Gegenkopplungspfad (56; 57) zumindest ein weiteres Detektorelement (45; 46; 47; 48) enthält,
**dadurch gekennzeichnet,**
**dass** der Detektor (2) ein erstes Detektorelement (22) und ein zweites Detektorelement (23) aufweist, die über eine Umschalteinrichtung (40) wechselweise mit dem ersten Eingang (52) und dem zweiten Eingang (53) des Gleichspannungsverstärkers (24) verbindbar sind.

2. Messvorrichtung nach Anspruch 1,
**dadurch gekennzeichnet,**
**dass** der erste Gegenkopplungspfad (56) ein drittes Detektorelement (45) und ein viertes Detektorelement (46) aufweist und dass der zweite Gegenkopplungspfad (57) ein fünftes Detektorelement (47) und ein sechstes Detektorelement (48) aufweist.

3. Messvorrichtung nach Anspruch 2,
**dadurch gekennzeichnet,**
**dass** das dritte Detektorelement (45) in dem ersten Rückkopplungspfad (56) und das fünfte Detektorelement (47) in dem zweiten Rückkopplungspfad (57) die Rückkopplung im Wesentlichen bestimmen, wenn das erste Detektorelement (22) mit dem ersten Eingang (52) und das zweite Detektorelement (23) mit dem zweiten Eingang (53) des Gleichspannungsverstärkers (24) verbunden sind und dass das vierte Detektorelement (46) in dem ersten Rückkopplungspfad (56) und das sechste Detektorelement (48) in dem zweiten Rückkopplungspfad (57) die Rückkopplung im Wesentlichen bestimmen, wenn das erste Detektorelement (22) mit dem zweiten Eingang (53) und das zweite Detektorelement (23) mit dem ersten Eingang (52) des Gleichspannungsverstärkers (24) verbunden sind.

4. Messvorrichtung nach Anspruch 2 oder 3,
**dadurch gekennzeichnet,**
**dass** die Detektorelemente (22; 23) Detektordioden sind.

5. Messvorrichtung nach Anspruch 4,
**dadurch gekennzeichnet,**
**dass** die Detektordioden des ersten und zweiten Detektorelements (22; 23) in entgegengesetzter Polarität über die Umschalteinrichtung (40) mit den Eingängen (52; 53) des Gleichspannungsverstärkers (24) verbunden sind.

6. Messvorrichtung nach Anspruch 4 der 5,

**dadurch gekennzeichnet,**
**dass** die Detektordioden des dritten und vierten Detektorelements (45; 46) in dem ersten Rückkopplungspfad (56) und die Detektordioden des fünften und sechsten Detektorelements (47, 48) in dem zweiten Rückkopplungspfad (57) antiparallel angeordnet sind.

7. Messvorrichtung nach einem der Ansprüche 1 bis 6,
**dadurch gekennzeichnet,**
**dass** der Gleichspannungsverstärker (24) ein Differenz-Verstärker ist, der ein zwischen dem ersten und zweiten Eingang (52; 53) anliegendes Differenz-Eingangssignal zu einem zwischen dem ersten und zweiten Ausgang (54; 55) anliegenden Differenz-Ausgangssignal ($U_{out}$) verstärkt.

8. Messvorrichtung nach Anspruch 7,
**dadurch gekennzeichnet,**
**dass** der Differenz-Verstärker (24) einen Regeleingang (61) zum Regeln der Symmetrie des Differenz-Ausgangs-signals ($u_{out}$) hat.

9. Messvorrichtung nach Anspruch 8,
**dadurch gekennzeichnet,**
**dass** die beiden Eingänge (52; 53) des Differenz-Verstärkers (24) über ein symmetrisches Netzwerk (41; 42) und einen Integrator (49; 50) mit dem Regeleingang (61) verbunden sind.

**Claims**

1. Measuring apparatus for a high-frequency signal having a detector (2) having at least one detector element (22; 23) and a DC voltage amplifier (24), connected downstream of the detector (2), having at least one input (52; 53) and at least one output (54; 55), wherein the DC voltage amplifier (24) has at least one negative-feedback path (56; 57) that extends from its at least one output (54; 55) to its at least one input (52; 53),
wherein the negative-feedback path (56; 57) contains at least one further detector element (45-48), wherein the further detector element (45-48) is essentially the same as the detector element (22; 23) and has the same characteristics as the detector element (22; 23), wherein the DC voltage amplifier (24) has a first input (52) and a second input (53) and also a first output (54) and a second output (55),
wherein the first output (54) is connected to the first input (52) via a first negative-feedback path (56) and the second output (55) is connected to the second input (53) via a second negative-feedback path (57) and wherein each negative-feedback path (56; 57) contains at least one further detector element (45; 46; 47; 48),
**characterized**
**in that** the detector (2) has a first detector element (22) and a second detector element (23), which are connectable to the first input (52) and the second input (53) of the DC voltage amplifier (24) alternately via a changeover device (40).

2. Measuring apparatus according to Claim 1,
**characterized**
**in that** the first negative-feedback path (56) has a third detector element (45) and a fourth detector element (46) and in that the second negative-feedback path (57) has a fifth detector element (47) and a sixth detector element (48).

3. Measuring apparatus according to Claim 2,
**characterized**
**in that** the third detector element (45) in the first feedback path (56) and the fifth detector element (47) in the second feedback path (57) essentially determine the feedback when the first detector element (22) is connected to the first input (52) and the second detector element (23) is connected to the second input (53) of the DC voltage amplifier (24) and in that the fourth detector element (46) in the first feedback path (56) and the sixth detector element (48) in the second feedback path (57) essentially determine the feedback when the first detector element (22) is connected to the second input (53) and the second detector element (23) is connected to the first input (52) of the DC voltage amplifier (24).

4. Measuring apparatus according to Claim 2 or 3,
**characterized**
**in that** the detector elements (22; 23) are detector diodes.

**5.** Measuring apparatus according to Claim 4,
**characterized**
**in that** the detector diodes of the first and second detector elements (22; 23) are connected to the inputs (52; 53) of the DC voltage amplifier (24) with opposite polarity via the changeover device (40).

**6.** Measuring apparatus according to Claim 4 or 5,
**characterized**
**in that** the detector diodes of the third and fourth detector elements (45; 46) in the first feedback path (56) and the detector diodes of the fifth and sixth detector elements (47, 48) in the second feedback path (57) are arranged parallel to one another in opposite directions.

**7.** Measuring apparatus according to one of Claims 1 to 6,
**characterized**
**in that** the DC voltage amplifier (24) is a differential amplifier that amplifies a differential input signal applied between the first and second inputs (52; 53) to produce a differential output signal ($U_{out}$) applied between the first and second outputs (54; 55).

**8.** Measuring apparatus according to Claim 7,
**characterized**
**in that** the differential amplifier (24) has a control input (61) for controlling the symmetry of the differential output signal (Uout).

**9.** Measuring apparatus according to Claim 8,
**characterized**
**in that** the two inputs (52; 53) of the differential amplifier (24) are connected to the control input (61) via a symmetric network (41; 42) and an integrator (49; 50).

**Revendications**

**1.** Dispositif de mesure pour un signal haute fréquence doté d'un détecteur (2) avec au moins un élément détecteur (22 ; 23) et d'un amplificateur de tension continue (24) relié en aval au détecteur (2) et pourvu d'au moins une entrée (52 ; 53) et d'au moins une sortie (54 ; 55),
dans lequel l'amplificateur de tension continue (24) présente au moins un trajet de rétroaction (56 ; 57) qui s'étend depuis sa au moins une sortie (54 ; 55) jusqu'à sa au moins une entrée (52 ; 53),
dans lequel dans le trajet de rétroaction (56 ; 57) se trouve au moins un autre élément détecteur (45-48),
dans lequel l'autre élément détecteur (45-48) est sensiblement identique à l'élément détecteur (22 ; 23) et présente la même caractéristique que l'élément détecteur (22 ; 23),
dans lequel l'amplificateur de tension continue (24) présente une première entrée (52) et une seconde entrée (53) ainsi qu'une première sortie (54) et une seconde sortie (55),
dans lequel la première sortie (54) est reliée à la première entrée (52) via un premier trajet de rétroaction (56) et la seconde sortie (55) est reliée à la seconde entrée (53) via un second trajet de rétroaction (57), et
dans lequel chaque trajet de rétroaction (56 ; 57) comprend au moins un autre élément détecteur (45 ; 46 ; 47 ; 48),
**caractérisé**
**en ce que** le détecteur (2) présente un premier élément détecteur (22) et un deuxième élément détecteur (23) qui peuvent être alternativement reliés à la première entrée (52) et à la seconde entrée (53) de l'amplificateur de tension continue (24) via un dispositif de commutation (40).

**2.** Dispositif de mesure selon la revendication 1,
**caractérisé**
**en ce que** le premier trajet de rétroaction (56) présente un troisième élément détecteur (45) et un quatrième élément détecteur (46), et le second trajet de rétroaction (57) présente un cinquième élément détecteur (47) et un sixième élément détecteur (48).

**3.** Dispositif de mesure selon la revendication 2,
**caractérisé**
**en ce que** le troisième élément détecteur (45) sur le premier trajet de rétroaction (56) et le cinquième élément détecteur (47) sur le second trajet de rétroaction (57) déterminent l'essentiel de la rétroaction lorsque le premier élément détecteur (22) est relié à la première entrée (52) et le deuxième élément détecteur (23) est relié à la seconde entrée (53) de l'amplificateur de tension continue (24), et en ce que le quatrième élément détecteur (46) sur le premier trajet de rétroaction (56) et le sixième élément détecteur (48) sur le second trajet de rétroaction (57) déterminent l'essentiel de la rétroaction lorsque le premier élément détecteur (22) est relié à la seconde entrée (53) et le deuxième élément détecteur (23) est relié à la première entrée (52) de l'amplificateur de tension continue (24).

4. Dispositif de mesure selon la revendication 2 ou 3,
**caractérisé**
**en ce que** les éléments détecteurs (22 ; 23) sont des diodes détectrices.

5. Dispositif de mesure selon la revendication 4,
**caractérisé**
**en ce que** les diodes détectrices du premier et du deuxième élément détecteur (22; 23) sont reliées aux entrées (52 ; 53) de l'amplificateur de tension continue (24) avec une polarité opposée et via le dispositif de commutation (40).

6. Dispositif de mesure selon la revendication 4 ou 5,
**caractérisé**
**en ce que** les diodes détectrices du troisième et du quatrième élément détecteur (45 ; 46) sur le premier trajet de rétroaction (56) et les diodes détectrices du cinquième et du sixième élément détecteur (47, 48) sur le second trajet de rétroaction (57) sont agencées de manière antiparallèle.

7. Dispositif de mesure selon l'une des revendications 1 à 6,
**caractérisé**
**en ce que** l'amplificateur de tension continue (24) est un amplificateur différentiel qui amplifie un signal d'entrée différentiel présent entre la première et la seconde entrée (52 ; 53) en un signal de sortie différentiel ($U_{out}$) présent entre la première et la seconde sortie (54 ; 55).

8. Dispositif de mesure selon la revendication 7,
**caractérisé**
**en ce que** l'amplificateur différentiel (24) dispose d'une entrée de réglage (61) destinée à régler la symétrie du signal de sortie différentiel ($U_{out}$).

9. Dispositif de mesure selon la revendication 8,
**caractérisé**
**en ce que** les deux entrées (52 ; 53) de l'amplificateur différentiel (24) sont reliées à l'entrée de réglage (61) via un circuit symétrique (41 ; 42) et un intégrateur (49; 50).

EP 2 021 812 B1

Messkopf 16

Grundgerät 17

T
1

2

3

4

5

A/D
6

7
- Nullpunktoffset

8

DSP
9

**Fig. 1**

(Stand der Technik)

Messkopf 16

T
1

2

x (+1)
x (-1)
10

3

11
Dither

A/D
6

7

13
- Dither

x (-1)
x (+1)
14

8

DSP
9

12

I    II

- Nullpunktoffset
Phase ...

**Fig. 2**

Fig. 3
(Stand der Technik)

$$u_{out} = v \cdot \left( \frac{u_{HF}^2}{n u_T} \cdot \frac{R_2}{R_0(T) + R_2} + u_n \right)$$

Fig. 4

11

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19955342 A1
- US 4970456 A
- DE 2422030 A1